# EUROPEAN PATENT APPLICATION

(11) **EP 4 561 307 A1**
(43) Date of publication of application: **28.05.2025**
(21) Application number: 23849347.2
(22) Date of filing: 31.07.2023
(51) Int. Cl.: H10K 30/40, H10K 30/50, H10K 30/88, H10K 71/12

(54) **PEROVSKITE SOLAR CELL WITH LOCAL SEMI-OPEN PASSIVATION CONTACT STRUCTURE AND PREPARATION METHOD THEREFOR**

(30) Priority: 02.08.2022 CN 202210919606
(71) Applicant: University of Science and Technology of China, Anhui 230000 (CN)
(72) Inventor: XU, Jixian, Hefei, Anhui 230000 (CN); PENG, Wei, Hefei, Anhui 230000 (CN)
(74) Representative: Chung, Hoi Kan
(86) International application number: PCT/CN2023/110204
(87) International publication number: WO 2024/027640

(57) **Abstract**

A perovskite solar cell with a local semi-opening passivation contact structure, which at least includes a charge transport layer and a perovskite layer. An insulating or low-conductivity material layer is provided between the charge transport layer and the perovskite layer, and the insulating or low-conductivity material layer is of a continuous or discontinuous island structure. By constituting the local semi-opening passivation contact structure between the charge transport layer and the insulating or low-conductivity material layer, a contact area between the charge transport layer and the perovskite layer can be reduced and non-radiative recombination at an interface can be reduced without affecting extraction and transport of carriers between the perovskite layer and the charge transport layer, which avoids conflict between passivation and charge transport, thus achieving a high open-circuit voltage and a high filling factor without reducing current density and making the passivation layer be set with a thickness in a large range; and it does not need high temperature, and characteristic of its local contact does not affect absorption of light by the perovskite layer.

## Description

### TECHNICAL FIELD

The disclosure belongs to the technical field of solar cells, and particularly relates to a perovskite solar cell with a semi-opening passivation contact structure and a preparation method thereof.

### BACKGROUND

Energy is important foundation for development of today's world, and photovoltaics, as a green energy source, provide an important way to solve energy problems. A perovskite solar cell has attracted wide attention because of its low manufacturing cost and simple structure. A structure of the perovskite solar cell can be a normal structure or an inverted structure. Currently, certificated highest efficiency of perovskite solar cells has reached 25.7%, from Ulsan National Institute of Science and Technology, Korea.

Preparation methods of the perovskite solar cells mainly include a solution method and a vapor-deposition method. The solution method is more widely used because of its simple preparation process and low production cost, and coverage and crystallinity of an obtained perovskite film are better. In the structure of the perovskite solar cell, a contact problem of a heterojunction is often one of potential reasons for poor performance of the cell. In order to reduce non-radiative recombination loss caused by heterojunction contact, a lot of research work have been done. Taking a mesoporous structure as an example, most of reported mesoporous structures are made of materials such as zirconia, alumina and titanium oxide and are applied at an interface. However, because such a structure needs high-temperature sintering, materials with a low melting point cannot be used before this high-temperature sintering step, otherwise, bottom materials below the mesoporous structure may be destroyed during the sintering, which greatly limits selection of device materials. Moreover, a passivation layer is usually inserted at interfaces in a planar structure. At present, commonly used materials of the passivation layer, such as an organic insulating material, an inorganic insulating material, an organic semiconductor material, an inorganic semiconductor material, an organic low-conductivity material and an inorganic low-conductivity material, all have high thickness requirements when used as the passivation layer, which basically cannot exceed 5 nm in thickness, because increase in thickness at a sub-nanometer level may cause blocked transmission, which may results in a sharp decline in current density and filling factor, and decrease in thickness at a nanometer level may cause loss of an open-circuit voltage, it is thus difficult to increase both the open-circuit voltage and the fill factor. Due to strict control requirements on the thickness of the passivation layer, large-scale production and application of the perovskite solar cells are limited.

Therefore, there is an urgent need for a perovskite solar cell that can solve problems that it is difficult to simultaneously improve the open-circuit voltage and the fill factor and to improve non-radiative recombination loss caused by the heterojunction contact for existing perovskite solar cells.

### SUMMARY

In view of shortcomings in related art mentioned above, a perovskite solar cell with a local semi-opening passivation contact structure is designed in the disclosure, which includes a charge transport layer (including an electron transport layer (abbreviated as ETL) and a hole transport layer (abbreviated as HTL)) and a local nanoscale opening insulating low-conductivity shielding layer, and has advantages of simultaneously passivating a perovskite interface and limiting current to pass through an opening.

In order to achieve above and other related objects, the disclosure provides a following technical scheme: a perovskite solar cell with a local semi-opening passivation contact structure at least includes a charge transport layer and a perovskite layer. An insulating or low-conductivity material layer is provided between the charge transport layer and the perovskite layer, and the insulating or low-conductivity material layer is of a continuous or discontinuous island structure.

As a new type of charge transport layer, the nanoscale semi-opening contact (NSC) structure described above can passivate interface defects without affecting carrier transport. According to different structures of cells, there are two kinds of charge transport layers: electron transport layer and hole transport layer. An insulating or low-conductivity material in an NSC charge transport layer is deposited on an upper (lower) interface between perovskite and the charge transport layer by a physical or chemical method.

Further, the charge transport layer is prepared by a physical deposition method or a chemical deposition method. The physical deposition method includes but is not limited to vacuum evaporation, sputtering, ion beam deposition, pulsed laser deposition, etc., and the chemical deposition method includes but is not limited to chemical vapor deposition, atomic layer deposition, sol-gel spin coating, etc.

Further, a horizontal scale of a continuous or discontinuous island is smaller than a diffusion length of a photo-generated carrier in the perovskite.

Further, a distance between islands is less than the horizontal scale of the island, and is 0.1 to 9 times the horizontal scale of the island.

Further, the island structure is needle-shaped, cone-shaped, columnar, spherical or flaky. The island structure has a height of 1 to 400 nm and a horizontal scale of 10 to 2000 nm. For example, an insulating low-conductivity precursor material is adopted as insulating oxide, which forms discontinuous island distribution between the charge transport layer and the perovskite layer, and openings are defined between islands. With presence of the NSC layer, carriers cannot be transported to the charge transport layer through the insulating oxide material, but can be transported only through a perovskite phase.

Further, coverage of the insulating or low-conductivity material layer is 5 to 99%, and the coverage is a percentage of an area where the insulating low-conductivity material shields and prevents carriers from being transported from the perovskite layer to the charge transport layer in a surface area of the charge transport layer, d is an average horizontal scale of the island structure and s is an average spacing of the island structure.

Further, in a device with the NSC structure, there are two transport paths for the carriers, one is a path a where the carriers are directly transported from the perovskite layer to a hole (electron) transport layer, and the other is a path b where the carriers are first diffused from the perovskite phase to the openings above the island-like insulating low-conductivity material, and then transported to the hole (electron) transport layer.

Further, the insulating or low-conductivity material layer can be adopted to contain, including but not limited to, groups such as hydroxyl, phosphoric acid, carboxylic acid, etc., and preferably an insulating or low-conductivity material capable of interacting with perovskite materials.

Further, the insulating or low-conductivity material layer includes an inorganic insulating or low-conductivity material, or an organic insulating or low-conductivity material, or a material wrapped by the insulating or low-conductivity material described above.

The inorganic insulating or low-conductivity material includes one or more of zirconia, alumina, iron oxide, lithium oxide, germanium oxide, silicon oxide, phosphorus pentoxide, boron oxide, magnesium oxide, chromium oxide, zirconium fluoride, aluminum fluoride, iron fluoride, germanium fluoride, silicon fluoride, boron fluoride, magnesium fluoride or lithium fluoride.

The organic insulating or low-conductivity material includes one or more of polyethylene, polypropylene, polytetrafluoroethylene, polyvinyl chloride, polycarbonate, polyacrylic acid, polyamide, polysulfone, polymethyl methacrylate, polyformaldehyde, phenolic resin, epoxy resin, melamine formaldehyde resin, polyimide, rubber, fiber, 2-phenylethylamine hydroiodide, piperazine diiodide, 1,8-octylenediamine hydroiodide or oleylamine iodine. Further, these insulating low-conductivity materials can also be composed of conductors and semiconductors (including but not limited to metal, fullerene, graphene, graphdiyne and other two-dimensional flaky materials and their derivatives) coated with the insulating or low-conductivity material described above, and a thickness of the insulating or low-conductivity coating material should make it be with sufficiently low conductance or even be insulated.

Further, the insulating or low-conductivity material layer is prepared by a physical deposition method or a chemical deposition method. The physical deposition method includes but is not limited to vacuum evaporation, sputtering, ion beam deposition, pulsed laser deposition, etc., and the chemical deposition method includes but is not limited to chemical vapor deposition, atomic layer deposition, sol-gel spin coating, etc. The island has an average horizontal scale of 10 to 2000 nm, an average height of 1 to 400 nm, and coverage of 5 to 99%.

Further, the cell structure is a p-i-n structure, which is composed of a transparent conductive substrate, an NSC hole transport layer, a perovskite layer, an electron transport layer and a back electrode from bottom to top.

Further, the cell structure is an n-i-p structure, which is composed of a transparent conductive substrate, an NSC electron transport layer, a perovskite layer, a hole transport layer and a back electrode from bottom to top.

Further, the structure is adopted with a NSC layer at both upper and lower sides, which is composed of a transparent conductive substrate, an NSC hole (electron) transport layer, a perovskite layer, an NSC electron (hole) transport layer and a back electrode from bottom to top.

Further, the cell structure is a perovskite-perovskite tandem structure, which is composed of a transparent conductive substrate, an NSC hole (electron) transport layer, a perovskite layer, an electron (hole) transport layer, a tunneling combination layer, an NSC hole (electron) transport layer, a perovskite layer, an electron (hole) transport layer and an electrode from bottom to top.

Further, the cell structure is a perovskite-silicon tandem structure, which is composed of a silicon cell, a transparent conductive oxide, an NSC hole (electron) transport layer, a perovskite layer, an electron (hole) transport layer and an electrode from bottom to top.

Further, the cell structure is a perovskite-CIGS structure, which is composed of a CIGS cell, a transparent conductive oxide, an NSC hole (electron) transport layer, a perovskite layer, an electron (hole) transport layer and an electrode from bottom to top.

A preparation method of the perovskite solar cell with the local semi-opening passivation contact structure is further provided in the disclosure, which specifically includes following steps:
1) preparing a hole transport layer or an electron transport layer on a clean transparent conductive oxide substrate;
2) preparing an insulating or low-conductivity material layer on the layer obtained in step 1);
3) depositing a perovskite layer on the layer obtained in step 2);
4) preparing an electron transport layer or a hole transport layer on the perovskite layer;
5) preparing a hole or electron blocking layer on the layer obtained in step 4); and
6) preparing a back electrode on the hole or electron blocking layer obtained in step 5).

Another preparation method of the perovskite solar cell with the local semi-opening passivation contact structure is further provided in the disclosure, which specifically includes following steps:
1) preparing a hole transport layer or an electron transport layer on a clean transparent conductive oxide substrate;
2) preparing an insulating or low-conductivity material layer on the layer obtained in step 1);
3) depositing a perovskite layer on the layer obtained in step 2);
4) preparing an electron transport layer or a hole transport layer on the perovskite layer;
5) preparing a dense layer on the layer obtained in step 4);
6) preparing a tunneling combination layer on the dense layer obtained in step 5);
7) preparing a hole transport layer or an electron transport layer on the tunneling combination layer obtained in step 6);
8) preparing an insulating or low-conductivity material layer on the layer obtained in step 7);
9) depositing a perovskite layer on the layer obtained in step 8);
10) preparing an electron transport layer or a hole transport layer on the layer obtained in step 9); and
11) preparing a back electrode on the layer obtained in step 10).

Further, the insulating or low-conductivity material layer is of a continuous or discontinuous island structure.

Further, a horizontal scale of a continuous or discontinuous island is smaller than a diffusion length of a photo-generated carrier in the perovskite, and a distance between islands is as small as possible relative to the horizontal scale of the island, and is about 0.1 to 9 times the horizontal scale of the island.

Further, the insulating or low-conductivity material layer is prepared by a physical deposition method or a chemical deposition method.

The physical deposition method is vacuum evaporation, sputtering, ion beam deposition or pulsed laser deposition.

The chemical deposition method is chemical vapor deposition, atomic layer deposition or sol-gel spin coating.

Definition of distance: In general, a distance refers to a nearest distance between two objects, and a distance between centers of two objects refers to a center distance.

With above technology, the disclosure has obvious advantages over the related art that:
1) The semi-open insulating low-conductivity shielding layer in the technical scheme of the present disclosure can be composed of island-like low-conductivity materials distributed separately (i.e., openings are distributed to be connected with each other) or low-conductivity materials distributed connectedly (i.e., the openings are distributed separately). By arranging the insulating low-conductivity material between the charge transport layer and the perovskite layer, the charge transport layer and the insulating low-conductivity material form a new charge transport structure and obtain effect of local nanoscale semi-opening contact (abbreviated as "NSC"), achieving effect of passivating the interface between the charge transport layer and the perovskite layer and reducing non-radiative recombination at the interface without affecting extraction and transport of carriers between the perovskite layer and the charge transport layer, which avoids conflict between passivation and charge transport, thus achieving a high open-circuit voltage and a high filling factor without reducing a current density and making the thickness insensitive in a large range.
2) The preparation process in the technical scheme of the disclosure does not need high temperature, and characteristic of its local contact does not affect absorption of light by the perovskite layer, and for a hydrophobic substrate material, contact between the perovskite layer and the charge transport layer can be enhanced, and full coverage of a perovskite film can be realized. The technical scheme of the disclosure can be applied to a single-junction perovskite solar cell, a perovskite-perovskite tandem cell, a silicon-perovskite tandem solar cell, a perovskite-CIGS tandem cell and the like and is also applicable to rigid and flexible substrates.
3) In this disclosure, the NSC charge transport structure can not only be used to passivate defects at the interface between the charge transport layer and the perovskite layer, reduce the non-radiative recombination loss and improve the open-circuit voltage, but also enhance transport of carriers at the interface, thus realizing improvement of both passivation and transport. Photoluminescence lifetime for NSC/ perovskite in the technical scheme of the disclosure is significantly prolonged to about 4 µs, causing the open-circuit voltage to reach more than 97% of a thermodynamic limit. These combined functions enable to improve efficiency of p-i-n devices from about 23% to 25.5% (certified 24.9%).
4) Because the NSC layer in the technical scheme of the disclosure can increase wettability of a surface of the hydrophobic base material, full coverage of perovskite and other materials can be promoted, which facilitates large-area preparation. Moreover, due to stability of the NSC layer, a corresponding device has excellent thermal stability, long-term storage stability and operational stability, which can obviously improve performance of perovskite solar cells while exhibiting a simple preparation process and low cost, and is suitable for large-scale commercial applications.

### BRIEF DESCRIPTION OF DRAWINGS

FIG. 1 shows a structure of a perovskite solar cell with a local semi-opening passivation contact structure according to the disclosure;
FIG. 2 is a schematic view of an island structure with a discontinuous insulating or low-conductivity material layer according to the disclosure (i.e., openings are distributed to be connected with each other);
FIG. 3 is a schematic view of an island structure with a continuous insulating or low-conductivity material layer according to the disclosure (i.e., the openings are distributed separately);
FIG. 4 is an atomic force microscope (AFM) image of alumina spin-coated on a HTL with island distribution according to the disclosure;
FIG. 5 is a cross-sectional graph of the alumina spin-coated on the HTL with island distribution according to the disclosure, corresponding to a cross section at a dotted line in FIG. 4;
FIG. 6 shows an experimental result obtained by spin-coating alumina dispersions with different concentrations on the HTL and resulting in different alumina coverage on the HTL according to the disclosure;
FIG. 7 shows a cross section of a perovskite solar cell of a p-i-n structure with a local semi-opening passivation contact structure according to the disclosure;
FIG. 8 shows current density-voltage (abbreviated as JV) curves of a perovskite solar cell of a p-i-n structure before and after a dense layer of 1 to 2 nm alumina is grown on the HTL using atomic layer deposition technology according to the disclosure;
FIG. 9 shows current density-voltage curves of a perovskite solar cell of a p-i-n structure with a local semi-opening passivation contact structure before and after passivation according to the disclosure;
FIG. 10 shows maximum power point tracking of a perovskite solar cell of a p-i-n structure with a local semi-opening passivation contact structure before and after passivation according to the disclosure;
FIG. 11 is a comparative view of Time-Resolved Photoluminescence (TRPL) of a perovskite solar cell of a p-i-n structure before and after passivation according to the disclosure;
FIG. 12 is a schematic structural view of a single-junction perovskite solar cell with a local semi-opening passivation contact structure according to disclosure (in which a NSC layer is provided at both sides of the perovskite layer);
FIG. 13 is a schematic structural view of a perovskite-perovskite tandem cell with a local semi-opening passivation contact structure according to the present disclosure (in which the perovskite structure is a p-i-n structure or an n-i-p structure, and the NSC layer is provided at a bottom side of the perovskite layer);
FIG. 14 is a schematic structural view of a silicon-perovskite tandem solar cell with a local semi-opening passivation contact structure according to the disclosure;

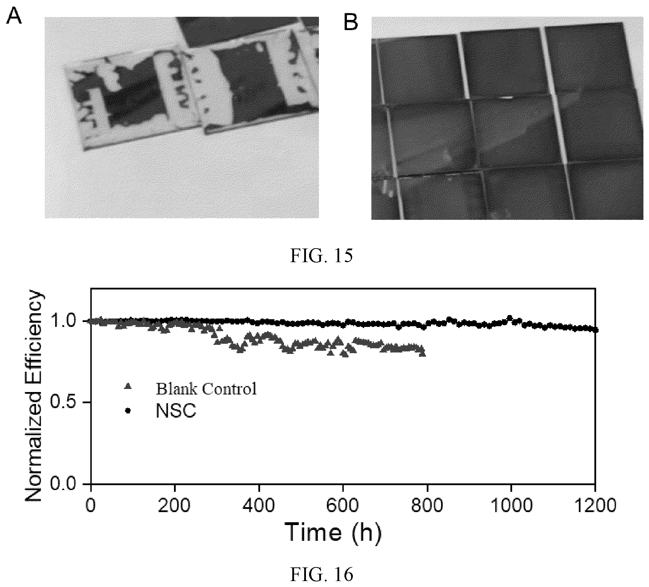

FIG. 15 is a picture showing a local semi-opening passivation contact structure promoting coverage of a perovskite thin film on a hole transport layer according to the disclosure, in which a panel A shows a perovskite thin film without a NSC structure and a panel B shows a perovskite thin film with the NSC structure; and
FIG. 16 shows stability tracking of a perovskite solar cell with or without a local semi-opening passivation contact structure according to the disclosure.

### DETAILED DESCRIPTION OF THE EMBODIMENTS

In order to better understand the present disclosure, the present disclosure will be further described in detail in connection with specific examples. These embodiments are intended to illustrate main reactions and basic features of the present disclosure. Without being limited by following examples, implementation conditions adopted in the examples can be further adjusted according to specific requirements, and unspecified implementation conditions are usually those in conventional experiments.

The present disclosure will be further explained by description of embodiments.

A structure of a NSC hole transport layer is designed in the disclosure, which is composed of a transparent conductive substrate, a NSC hole transport layer, a perovskite layer, an electron transport layer, and a back electrode. An insulating or low conductivity material in the NSC layer adopts 20 wt% isopropanol dispersions with alumina, zirconia and silica commercially available.

Specifically, in a p-i-n or n-i-p structure, a hole dense layer can be selected as an inorganic hole transport layer made of: nickel oxide (NiO), molybdenum oxide (MoO₃), cuprous oxide (Cu₂O), copper iodide (CuI), copper phthalocyanine (CuPc), cuprous thiocyanate (CuSCN) and redox graphene; or an organic hole transport layer made of one or more p-type semiconductor materials such as poly[bis(4-phenyl)(2,4,6-trimethylphenyl)amine] (PTAA), (n-(3,6-Dimethyl-9H-carbazol-9-yl)butyl) phosphonic acid (Me-nPACz) (where n = 1, 2, 3, 4, 5 ...), 2-(9H-Carbazol-9-yl)ethyl]phosphonic acid (2-PACz), 2,2',7,7'--tetrakis[N,N-di(4-methoxyphenyl)amino]-9,9'-spirobifluorene (Spiro-OMeTAD), poly(3,4-ethylenedioxythiophene): poly(styrenesulfonate) (PEDOT: PSS), poly[N,N'-bis(4-butylphenyl)-N,N'-bis(phenyl)-benzi] (Ploy-TPD) and polyvinylcarbazole (PVK), but not limited to the p-type semiconductor materials listed above. An electron dense layer can selected to be made of one or more n-type semiconductor materials such as titanium oxide (TiO₂), tin oxide (SnO₂), zinc oxide (ZnO), vanadium oxide (V₂O₅), zinc tin oxide (Zn₂SnO₄), fullerenes (C60, C70, etc.) and their derivatives, but not limited to the n-type semiconductor materials listed above.

In the disclosure, the NSC layer can not only function in passivating interface defects, reducing non-radiative recombination loss and improving the open-circuit voltage, but also facilitate faster transport of carriers through a perovskite phase, thus improving a filling factor and realizing improvement of both passivation and transport. Meanwhile, due to its hydrophilicity, it can improve wettability of a surface of a base material, promote full coverage of perovskite films, and facilitate preparation of large-area devices. Meanwhile, stability of an insulating or low-conductivity precursor material in the NSC layer itself also promotes stability of devices to some extent.

In the disclosure, the insulating low-conductivity precursor material in the NSC layer is anchored to a perovskite surface through physical and chemical actions, with uniform or nonuniform distribution, which passivates the surface without affecting carrier transport; meanwhile, the insulating low-conductivity precursor material with low thermal expansion coefficient facilitates controlling of stress change between the perovskite and the charge transport layer, thus improving the mechanical stability of the perovskite cell.

### Example 1

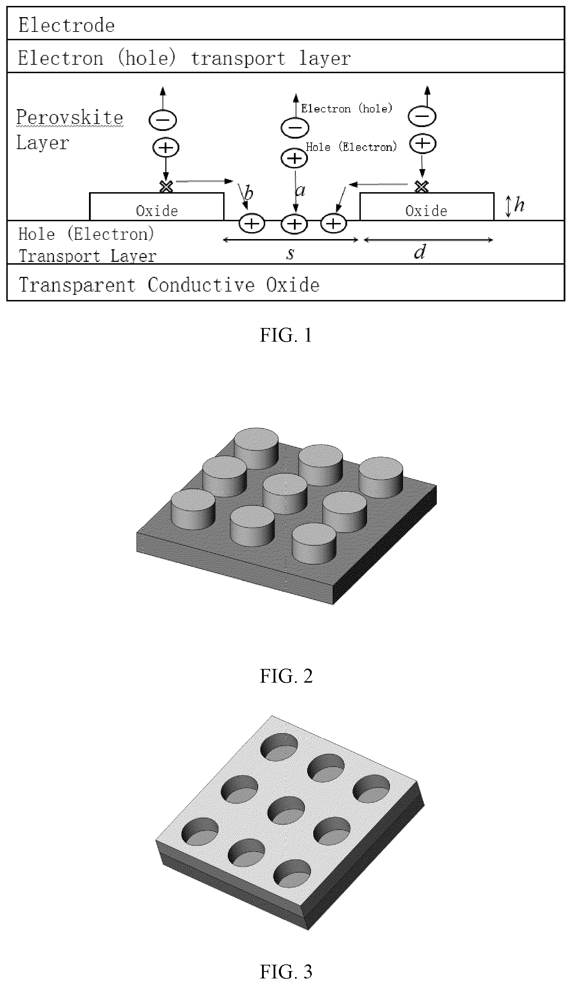

A preparation process of a perovskite solar cell of a p-i-n structure shown in FIG. 1 is specifically as follows:
1) preparing a layer of (4-(3,6-Dimethyl-9H-carbazol-9-yl)butyl) phosphonic acid (Me-4PACz) of about 20 nm on a clean transparent conductive oxide substrate as a hole transport layer;
2) spin-coating diluted alumina dispersion with a thickness of 100 nm on the prepared hole transport layer to form an insulating low-conductivity layer with island distribution, so as to form an NSC hole transport layer with the hole transport layer in step 1 as a part of an NSC device, with no insulating low-conductivity layer with island distribution as a blank control device;
3) depositing a layer of perovskite with a thickness of about 500 nm on a basis of step 2;
4) preparing a layer of fullerene (C60) as an electron transport layer by thermal evaporation, with a thickness of about 30 nm;
5) preparing a layer of bathocuproine (BCP) as a hole blocking layer by thermal evaporation, with a thickness of about 8 nm;
6) finally evaporating a layer of Ag with a thickness of 100 nm by thermal evaporation as a back electrode; and
7) using the device prepared in step 6 to perform JV curve tests and maximum power point tracking.

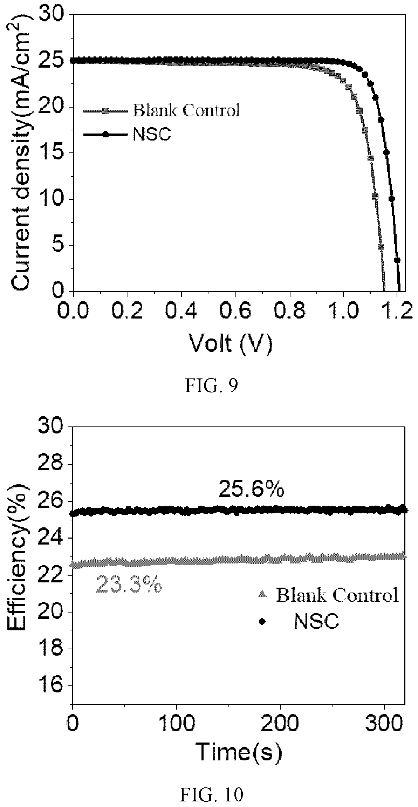

As shown in FIGS. 9 and 10, it is found that with use of the NSC layer, performance of the device can be improved. Without use of the NSC layer, the device has photoelectric conversion efficiency of 22.83%, an open-circuit voltage of 1.15 V, a fill factor of 79.14%, short-circuit current density of 25.01 mA/cm², and steady-state efficiency obtained by the maximum power point tracking of 23.3%; and with use of the NSC layer, the photoelectric conversion efficiency can be increased to 25.50%, the open-circuit voltage is 1.21 V, the fill factor is 84.37%, the short-circuit current density is 25.11 mA/cm², and the steady-state efficiency obtained by the maximum power point tracking is 25.6%. Therefore, With the use of the NSC hole transport layer, it is facilitated to improve the open-circuit voltage and the filling factor at the same time, without affecting the short circuit current density.

### Example 2

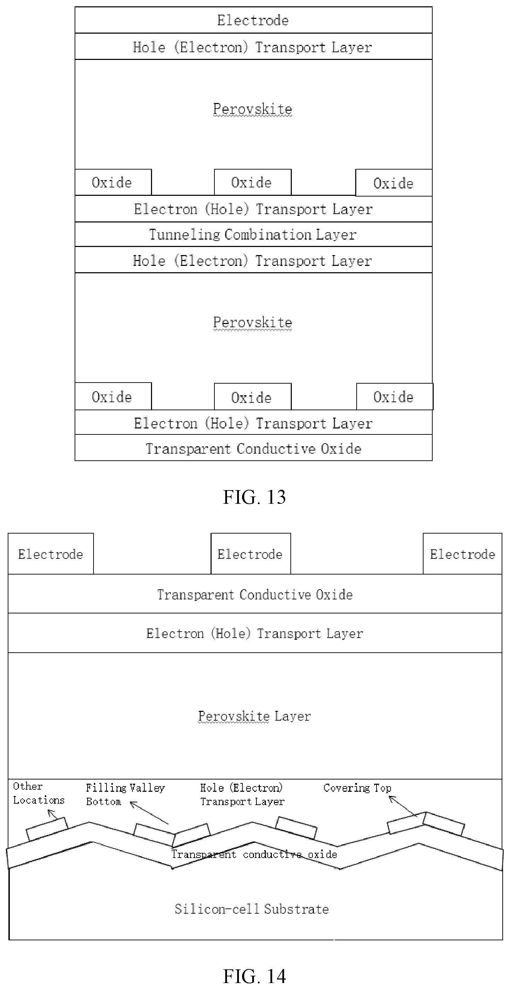

A preparation process of a p-i-n tandem perovskite solar cell shown in FIG. 13 is specifically as follows:
1) preparing a layer of poly[bis(4-phenyl)(2,4,6-trimethylphenyl)amine] (PTAA) of about 20 nm on a clean transparent conductive oxide substrate as a hole transport layer;
2) spin-coating diluted alumina dispersion with a thickness of 100 nm on the prepared hole transport layer to form an insulating low-conductivity layer, so as to form an NSC hole transport layer with the hole transport layer in step 1;
3) depositing a layer of perovskite with a wide band-gap on the prepared NSC layer, with a thickness of about 300 nm;
4) preparing a layer of fullerene (C60) as an electron transport layer by thermal evaporation, with a thickness of about 18 nm;
5) growing a layer of SnO2 on C60 as a dense layer by atomic layer deposition, with a thickness of 15 nm;
6) thermally evaporating Au to form a tunneling combination layer, with a thickness of 2 nm;
7) preparing a hole transport layer using poly(3,4-ethylenedioxythiophene): poly(styrenesulfonate) (PEDOT: PSS);
8) spin-coating diluted alumina dispersion with a thickness of 100 nm on the prepared hole transport layer to form an insulating low-conductivity layer, so as to form an NSC hole transport layer with the hole transport layer in step 7;
9) depositing a layer of perovskite with a narrow band-gap on the prepared NSC layer, with a thickness of 1000 nm;
10) preparing a double-layer structure of C60 and 2,9-Dimethyl-4,7-diphenyl-1,10-phenanthroline (BCP) by thermal evaporation, with thicknesses of 30 nm and 5 nm respectively; and
11) finally evaporating a layer of Ag with a thickness of 150 nm by thermal evaporation as a back electrode.

### Example 3

A preparation process of a perovskite solar cell of a p-i-n structure shown in FIG. 1 is specifically as follows:
1) preparing a layer of (4-(3,6-Dimethyl-9H-carbazol-9-yl)butyl) phosphonic acid (Me-4PACz) of about 20 nm on a clean transparent conductive oxide substrate as a hole transport layer;
2) spin-coating diluted alumina dispersions with different concentrations with a thickness of 100 nm on the prepared hole transport layer to form an insulating low-conductivity layer with incomplete coverage or island distribution, so as to form an NSC hole transport layer with the hole transport layer in step 1, with a concentration range of 0 to 4 mg/mL, in which 0 mg/mL serves as a blank control;
3) depositing a layer of perovskite with a thickness of about 500 nm on a basis of step 2;
4) preparing a layer of fullerene (C60) as an electron transport layer by thermal evaporation, with a thickness of about 30 nm;
5) preparing a layer of bathocuproine (BCP) as a hole blocking layer by thermal evaporation, with a thickness of about 8 nm; and
6) finally evaporating a layer of Ag with a thickness of 100 nm by thermal evaporation as a back electrode.

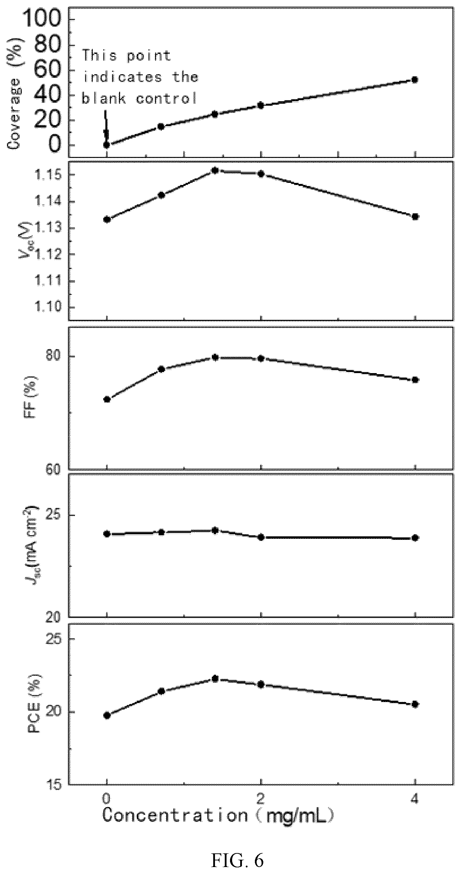

Experimental results are shown in FIG. 6. With increase of the concentration of the alumina dispersion, the coverage is obviously improved. With increase of the coverage, it can be seen that the open-circuit voltage, the filling factor and the efficiency first increase and then decrease, reaching maximum in a range of 1.4 to 2 mg/mL. Experimental conclusion in this embodiment is that the coverage in a range of 20 to 35% most facilitates performance of NSC devices.

### Example 4

A preparation process of a perovskite solar cell of a p-i-n structure shown in FIG. 1 is specifically as follows:
1) preparing a layer of (4-(3,6-Dimethyl-9H-carbazol-9-yl)butyl) phosphonic acid (Me-4PACz) of about 20 nm on a clean transparent conductive oxide substrate as a hole transport layer;
2) spin-coating diluted zirconia dispersion with a thickness of 100 nm on the prepared hole transport layer to form an insulating low-conductivity layer with incomplete coverage or island distribution, so as to form an NSC hole transport layer with the hole transport layer in step 1;
3) depositing a layer of perovskite on the prepared NSC layer, with a thickness of about 500 nm;
4) preparing a layer of fullerene (C60) as an electron transport layer by thermal evaporation, with a thickness of about 30 nm;
5) preparing a layer of bathocuproine (BCP) as a hole blocking layer by thermal evaporation, with a thickness of about 8 nm; and
6) finally evaporating a layer of Ag with a thickness of 100 nm by thermal evaporation as a back electrode.

With use of the NSC layer, performance of the device is improved. Without use of the NSC layer, photoelectric conversion efficiency of the device is 22.83%; and with use of the NSC layer, the photoelectric conversion efficiency can be improved to 25.28%.

### Example 5

A preparation process of a perovskite solar cell of a p-i-n structure shown in FIG. 1 is specifically as follows:
1) preparing a layer of (4-(3,6-Dimethyl-9H-carbazol-9-yl)butyl) phosphonic acid (Me-4PACz) of about 20 nm on a clean transparent conductive oxide substrate as a hole transport layer;
2) spin-coating diluted silica dispersion with a thickness of 100 nm on the prepared hole transport layer to form an insulating low-conductivity layer with incomplete coverage or island distribution, so as to form an NSC hole transport layer with the hole transport layer in step 1;
3) depositing a layer of perovskite on the prepared NSC layer, with a thickness of about 500 nm;
4) preparing a layer of fullerene (C60) as an electron transport layer by thermal evaporation, with a thickness of about 30 nm;
5) preparing a layer of bathocuproine (BCP) as a hole blocking layer by thermal evaporation, with a thickness of about 8 nm; and
6) finally evaporating a layer of Ag with a thickness of 100 nm by thermal evaporation as a back electrode.

With use of the NSC layer, performance of the device is improved. Without use of the NSC layer, photoelectric conversion efficiency of the device is 22.83%; and with use of the NSC layer, the photoelectric conversion efficiency can be improved to 25.13%.

### Comparative Example 1

1) preparing a layer of (4-(3,6-Dimethyl-9H-carbazol-9-yl)butyl) phosphonic acid (Me-4PACz) of about 20 nm on a clean transparent conductive oxide substrate as a hole transport layer;
2) growing an alumina layer with complete coverage with a thickness of about 1 to 2 nm on the prepared hole transport layer by atomic layer deposition (ALD) technology;
3) depositing a layer of perovskite on the prepared alumina layer, with a thickness of about 500 nm;
4) preparing a layer of fullerene (C60) as an electron transport layer by thermal evaporation, with a thickness of about 30 nm;
5) preparing a layer of bathocuproine (BCP) as a hole blocking layer by thermal evaporation, with a thickness of about 8 nm; and
6) finally evaporating a layer of Ag with a thickness of 100 nm by thermal evaporation as a back electrode.

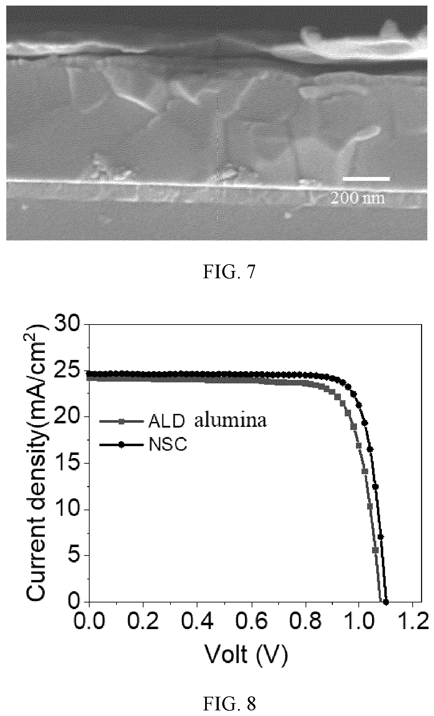

As shown in FIG. 8, performance of the device is not improved with use of the ALD alumina layer. Compared with the device with the NSC structure, the short-circuit current density is reduced from 24.63 mA/cm² to 24.20 mA/cm², the fill factor is reduced from 82.26% to 78.19%, the open-circuit voltage is reduced from 1.10 V to 1.08 V, and the efficiency is reduced from 22.29% to 20.41%. Decrease of the short-circuit current density and the filling factor once again shows that a passivation layer of this traditional ultra-thin insulating oxide is sensitive to its thickness, which generally increases transport resistance, is not conducive to extraction and transport of carriers, and causes loss of device performance.

### Example 6

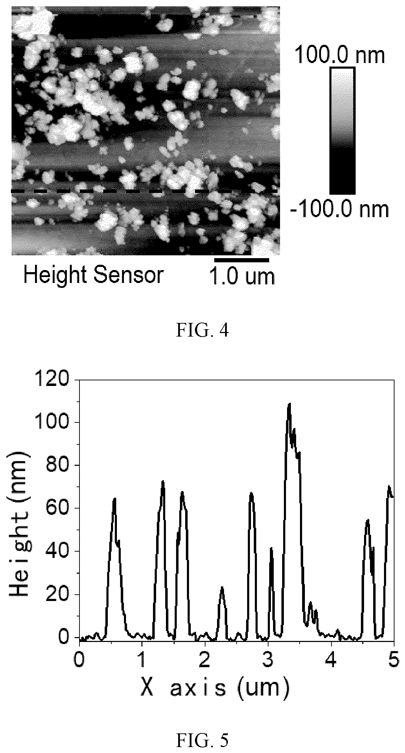

A preparation process of an AFM image sample shown in FIG. 4 is specifically as follows:
1) preparing a layer of (4-(3,6-Dimethyl-9H-carbazol-9-yl)butyl) phosphonic acid (Me-4PACz) of about 20 nm on a clean transparent conductive oxide substrate as a hole transport layer;
2) spin-coating diluted alumina dispersion of 1.4 mg/mL with a thickness of 100 nm on the prepared hole transport layer to form an insulating low-conductivity layer with island distribution, so as to form an NSC hole transport layer with the hole transport layer in step 1; and
3) taking an AFM image of a sample prepared in step 2, using Brooke brand instruments and equipment and a chrome/gold-plated silicon cantilever in a tapping mode with a resonant frequency of 160 kHz and a torque constant of 5 N/m. All images have same scanning parameters: 256 points/ µm, 1s/line, and 1s/retry.

Test results show that alumina forms clusters on the HTL, showing discontinuous island distribution.

### Example 7

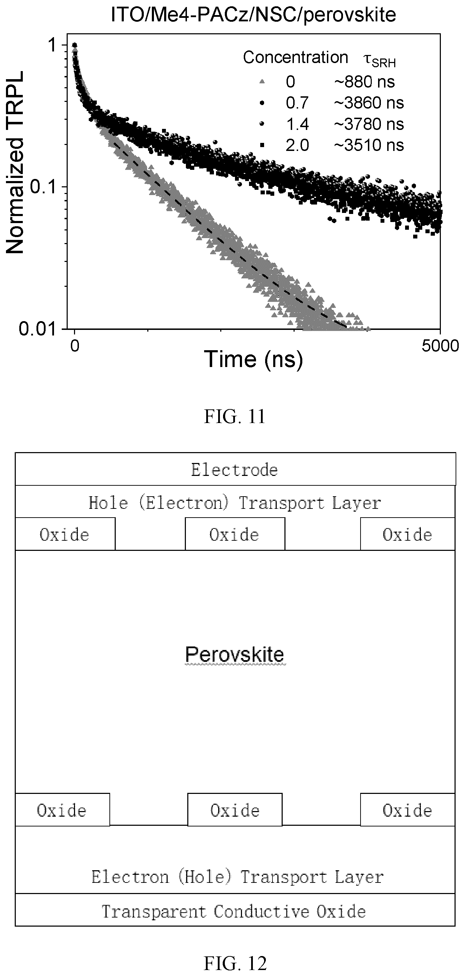

A preparation process of a TRPL image sample shown in FIG. 11 is specifically as follows:
1) preparing a layer of (4-(3,6-Dimethyl-9H-carbazol-9-yl)butyl) phosphonic acid (Me-4PACz) of about 20 nm on a clean transparent conductive oxide substrate as a hole transport layer;
2) spin-coating diluted alumina dispersions of concentrations of 0.7 to 2 mg/mL with a thickness of 100 nm on the prepared hole transport layer to form an insulating low-conductivity layer with island distribution, so as to form an NSC hole transport layer with the hole transport layer in step 1, with no insulating low-conductivity layer with island distribution as a blank control sample; and
3) performing a TRPL test on a sample prepared in step 2, with an excitation wavelength of 450 nm, a standard pulse time of 80 ps, and an average energy injection of 3 mW.

Test results show that with the use of the NSC layer, carrier lifetime in the sample is obviously improved, from 880 ns in the blank control sample to more than 3500 ns. Obvious improvement of the carrier lifetime shows that non-radiative recombination in the sample is effectively suppressed, which proves that the NSC structure facilitates improvement of the open-circuit voltage.

The above embodiments are only the preferred technical schemes of the present disclosure, and should not be regarded as limitation on the present disclosure. The protection scope of the present disclosure should be subject to the technical schemes described in the claims, including equivalent alternative technical schemes for technical features in the technical schemes described in the claims, that is, equivalent substitution and improvement within this scope is also within the protection scope of the present disclosure.

## Claims

1. A perovskite solar cell with a local semi-opening passivation contact structure at least comprising a charge transport layer and a perovskite layer, wherein an insulating or low-conductivity material layer is provided between the charge transport layer and the perovskite layer, and the insulating or low-conductivity material layer is of a continuous or discontinuous island structure.

2. The perovskite solar cell according to claim 1, wherein a horizontal scale of a continuous or discontinuous island is smaller than a diffusion length of a photo-generated carrier in the perovskite; and
preferably a distance between islands is 0.1 to 9 times the horizontal scale of the island.

3. The perovskite solar cell according to claim 1, wherein the island structure is needle-shaped, cone-shaped, columnar, spherical or flaky, and the island structure has a height of 1 to 400 nm and a horizontal scale of 10 to 2000 nm; and
preferably the height and the horizontal scale of the island structure are matched with a diffusion length of a photo-generated carrier.

4. The perovskite solar cell according to claim 1, wherein coverage of the insulating or low-conductivity material layer is 5 to 99%, and the coverage is a percentage of an area where the insulating low-conductivity material shields and prevents carriers from being transported from the perovskite layer to the charge transport layer in a surface area of the charge transport layer.

5. The perovskite solar cell according to claim 4, wherein the insulating or low-conductivity material layer comprises an inorganic insulating or low-conductivity material, or an organic insulating or low-conductivity material, or an insulating or low-conductivity material formed by wrapping a conductor or semiconductor with the insulating or low-conductivity material;
the inorganic insulating or low-conductivity material comprises one or more of zirconia, alumina, iron oxide, lithium oxide, germanium oxide, silicon oxide, phosphorus pentoxide, boron oxide, magnesium oxide, chromium oxide, zirconium fluoride, aluminum fluoride, iron fluoride, germanium fluoride, silicon fluoride, boron fluoride, magnesium fluoride or lithium fluoride; and
the organic insulating or low-conductivity material comprises one or more of polyethylene, polypropylene, polytetrafluoroethylene, polyvinyl chloride, polycarbonate, polyacrylic acid, polyamide, polysulfone, polymethyl methacrylate, polyformaldehyde, phenolic resin, epoxy resin, melamine formaldehyde resin, polyimide, rubber, fiber, 2-phenylethylamine hydroiodide, piperazine diiodide, 1,8-octylenediamine hydroiodide or oleylamine iodine.

6. A preparation method of the perovskite solar cell with the local semi-opening passivation contact structure according to any one of claims 1 to 5, comprising following steps:
1) preparing a hole transport layer or an electron transport layer on a clean transparent conductive oxide substrate;
2) preparing an insulating or low-conductivity material layer on the layer obtained in step 1);
3) depositing a perovskite layer on the layer obtained in step 2);
4) preparing an electron transport layer or a hole transport layer on the perovskite layer;
5) preparing a hole or electron blocking layer on the layer obtained in step 4); and
6) preparing a back electrode on the hole or electron blocking layer obtained in step 5).

7. A preparation method of the perovskite solar cell with the local semi-opening passivation contact structure according to any one of claims 1 to 5, comprising following steps:
1) preparing a hole transport layer or an electron transport layer on a clean transparent conductive oxide substrate;
2) preparing an insulating or low-conductivity material layer on the layer obtained in step 1);
3) depositing a perovskite layer on the layer obtained in step 2);
4) preparing an electron transport layer or a hole transport layer on the perovskite layer;
5) preparing a dense layer on the layer obtained in step 4);
6) preparing a tunneling combination layer on the dense layer obtained in step 5);
7) preparing a hole transport layer or an electron transport layer on the tunneling combination layer obtained in step 6);
8) preparing an insulating or low-conductivity material layer on the layer obtained in step 7);
9) depositing a perovskite layer on the layer obtained in step 8);
10) preparing an electron transport layer or a hole transport layer on the layer obtained in step 9); and
11) preparing a back electrode on the layer obtained in step 10).

8. The preparation method according to claim 6 or 7, wherein the insulating or low-conductivity material layer is of a continuous or discontinuous island structure.

9. The preparation method according to claim 6, wherein a horizontal scale of a continuous or discontinuous island is smaller than a diffusion length of a photo-generated carrier in the perovskite;
preferably a distance between islands is 0.1 to 9 times the horizontal scale of the island; or
preferably the distance between islands and the horizontal scale of the island ensure that coverage of the insulating or low-conductivity material layer is 5 to 99%, and the coverage is a percentage of an area where the insulating low-conductivity material shields and prevents carriers from being transported from the perovskite layer to the charge transport layer in a surface area of the charge transport layer.

10. The preparation method according to claim 6, wherein the insulating or low-conductivity material layer is prepared by a physical deposition method or a chemical deposition method;
the physical deposition method is vacuum evaporation, sputtering, ion beam deposition or pulsed laser deposition; and
the chemical deposition method is chemical vapor deposition, atomic layer deposition or sol-gel spin coating.
